# EUROPEAN PATENT APPLICATION

(11) **EP 0 907 243 A2**
(43) Date of publication of application: **07.04.1999**
(21) Application number: 98116804.0
(22) Date of filing: 04.09.1998
(51) Int. Cl.: H03H 9/17, H03H 9/58

(54) **Electronic component and ladder filter**

(30) Priority: 03.10.1997 JP 287673/97
(71) Applicant: Murata Manufacturing Co., Ltd., Nagaokakyo-shi Kyoto-fu 617-8555 (JP)
(72) Inventor: Sakai, Norio, Nagaokakyo-shi, Kyoto-fu 617-8555 (JP); Unami, Toshihiko, Nagaokakyo-shi, Kyoto-fu 617-8555 (JP); Kubota, Kenji c/o(A107) Intellectual Property Dept, Nagaokakyo-shi, Kyoto-fu 617-8555 (JP)
(74) Representative: Zinnecker, Armin, Dipl.-Ing.

(57) **Abstract**

On a first major surface of a substrate 12 of a ladder filter 10, pattern electrodes 14a to 14e and lands 16a to 16e are provided. Lamination-structure piezoelectric resonators 20a1, 20a2, 20b1, and 20b2 are connected to the lands 16a to 16e. A metal cap 40 is bonded to the pattern electrodes 14d and 14e with electrically conductive adhesive at the periphery of the substrate 12 so as to cover the piezoelectric resonators. On the second major surface of the substrate 12, pattern electrodes 18a to 18c which are connected to the pattern electrode 14a, 14c, and 14d through via holes 12a to 12c are provided.

The above electric component is a surface-mountable, lamination-structure piezoelectric resonator, which can be made to have a low profile, and in which a defect caused by a short-circuit is unlikely to occur, and an adverse effect on the characteristics is unlikely to happen.

## Description

### BACKGROUND OF THE INVENTION

### 1. Technical Field of the Invention

The present invention relates to electronic components and ladder filters, and more particularly, to an electronic component, such as a ladder filter using a piezoelectric resonator which uses a mechanical resonance of a piezoelectric member.

### 2. Description of the Related Art

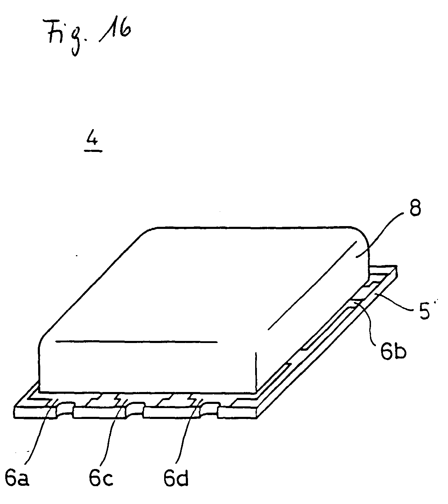

Fig. 15 is a perspective view of a conventional piezoelectric resonator. A piezoelectric resonator 1 includes a piezoelectric substrate 2 having, for example, a rectangular plate shape viewed from above. The piezoelectric substrate 2 is polarized in the thickness direction. On both surfaces of the piezoelectric substrate 2, electrodes 3 are provided. When a signal is input between the electrodes 3, an electrical field is applied to the piezoelectric substrate 2 in the thickness direction and the piezoelectric substrate 2 vibrates in the longitudinal direction.

The piezoelectric resonator shown in Fig. 15 is of an unstiffened type, in which the vibration direction differs from the direction of polarization and the electrical field. The electromechanical coupling coefficient of such an unstiffened piezoelectric resonator is lower than that of a stiffened piezoelectric resonator, in which the vibration direction, the direction of polarization, and the direction in which an electrical field is applied are the same. An unstiffened piezoelectric resonator has a relatively small frequency difference ΔF between the resonant frequency and the antiresonant frequency. This leads to a drawback in which a frequency bandwidth in use is narrow when an unstiffened piezoelectric resonator is used as a filter. Therefore, the degree of freedom in characteristics design is low in electronic components using such a piezoelectric resonator, including a filter and an oscillator.

The piezoelectric resonator shown in Fig. 15 uses the first-order resonance in the longitudinal mode. It also generates due to its structure large spurious resonances in odd-number harmonic modes, such as the third-order and fifth-order modes, and in width mode. To suppress these spurious resonances, some measures are considered, such as polishing, increasing mass, and changing the shape of the electrodes. These measures increase manufacturing cost.

In addition, since when viewed from above the piezoelectric substrate has a rectangular plate shape, the substrate cannot be thinner due to restrictions in strength. Therefore, the distance between the electrodes cannot be reduced and a capacitance between terminals cannot be made large. This is extremely inconvenient for achieving impedance matching with an external circuit. To form a ladder filter by connecting a plurality of piezoelectric resonators in series and in parallel alternately, the capacitance ratio of the series resonator to the parallel resonator needs to be made large in order to increase attenuation. Because a piezoelectric resonator has the shape restriction described above, however, a large attenuation cannot be obtained.

In Japanese Unexamined Patent Publication No. 8-110475, which has been filled by the same applicant as for this application, a piezoelectric resonator having a lamination structure which excites a longitudinal fundamental vibration has been proposed, in which a plurality of piezoelectric layers and a plurality of electrodes are laminated to form a base member having a longitudinal direction and the plurality of piezoelectric layers are polarized in the longitudinal direction of the base member. A piezoelectric resonator having such a lamination structure is of a stiffened type, and has the piezoelectric layers in which the vibration direction, the direction of polarization, and the direction in which an electrical field is applied are the same. The piezoelectric resonator has a smaller spurious resonance and a larger difference ΔF between the resonant frequency and the antiresonant frequency than an unstiffened piezoelectric resonator.

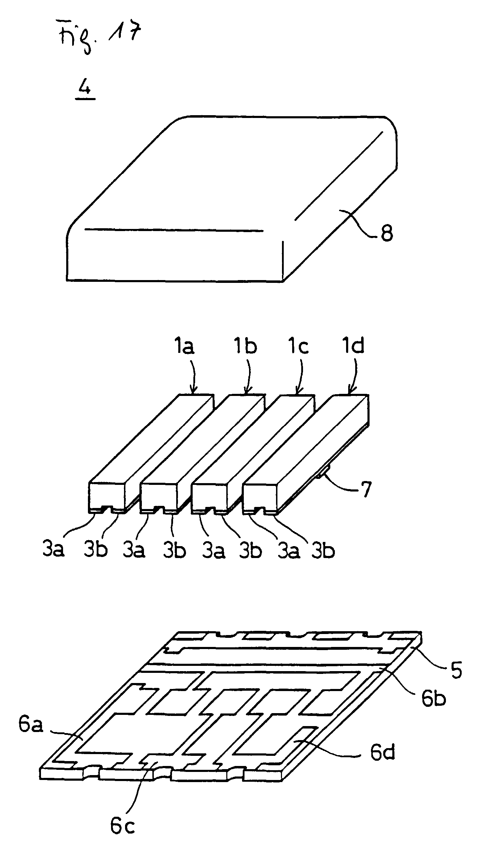

To make a ladder filter with the use of a piezoelectric resonator having such a lamination structure, a structure shown in Figs. 16 to 20, for example, can be considered.

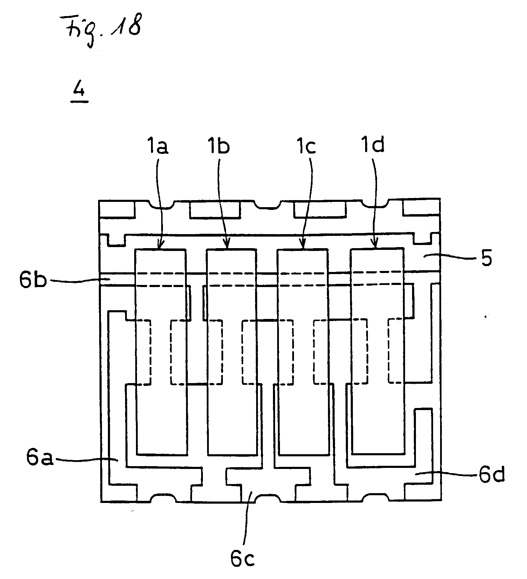

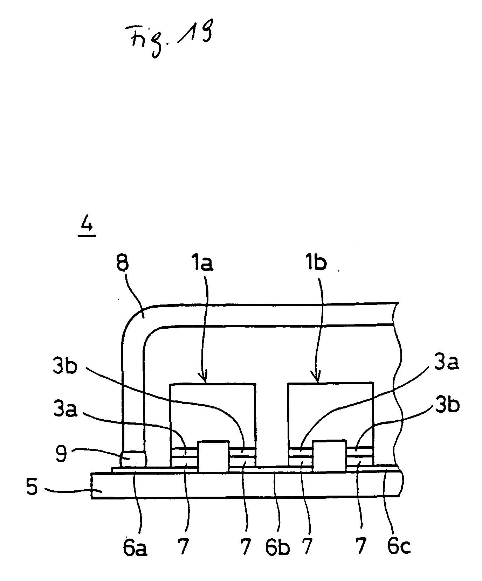

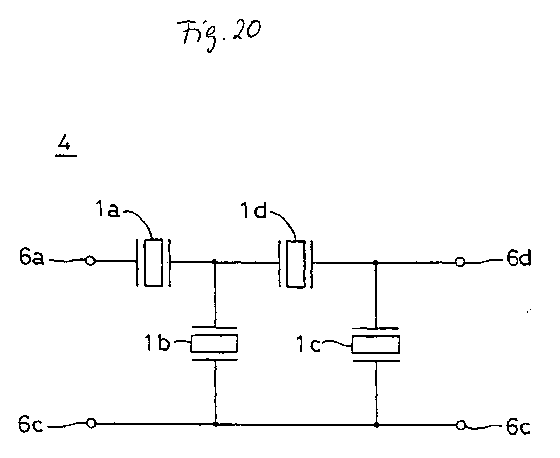

Fig. 16 is a perspective view of a ladder filter serving as a background of the present invention. Fig. 17 is an exploded perspective view of the ladder filter, and Fig. 18 is a plan of the ladder filter. Fig. 19 is a cross section of a main section of the ladder filter, and Fig. 20 is a circuit diagram of the ladder filter. The ladder filter 4 shown in Figs. 16 to 20 includes an insulating substrate 5. On the insulating substrate 5, four pattern electrodes 6a, 6b, 6c, and 6d are provided. Piezoelectric resonators 1a, 1b, 1c, and 1d having the lamination structure described above are electrically connected to these pattern electrodes 6a to 6d. In this case, two external electrodes 3a and 3b are provided with a gap in the width direction of each of the piezoelectric resonators 1a, 1b, 1c, and 1d on one side surface of each of the piezoelectric resonators 1a to 1d. At the centers of the external electrodes 3a and 3b in the longitudinal direction, support members 7 made from an electrically conductive material are provided. These support members 7 are bonded and connected to the pattern electrodes 6a to 6d with electrically conductive adhesive. This ladder filter 4 has a ladder circuit shown in Fig. 20. These piezoelectric resonators 1a to 1d vibrates in their longitudinal directions. On the insulating substrate 5, a cap 8 made from resin or ceramic is bonded with an adhesive layer 9 so as to cover the four piezoelectric resonators 1a to 1d, in order not to prevent the vibrations of the piezoelectric resonators.

In the ladder filter 4 shown in Figs. 16 to 20, since the external electrodes 3a and 3b are provided on one side surface of each of the piezoelectric resonators 1a to 1d, and the support members 7 made from the electrically conductive material are provided on the external electrodes 3a and 3b, the piezoelectric resonators 1a to 1d can be surface-mounted on the insulating substrate 5.

In the ladder filter 4 shown in Figs. 16 to 20, since the pattern electrodes 6a to 6d are extended to edges of the insulating substrate 5 and they are long, large inductive components are generated and they may cause a problem in the characteristics in a high-frequency band such as the MHz band.

In the ladder filter 4 shown in Figs. 16 to 20, since the cap 8 is made from resin or ceramic, there is a limit of the thickness of the cap 8 even if it is formed thinner or the drawing height is reduced. Therefore, it is difficult to make a low-profile ladder filter.

When a metal cap 8 is used in order to make a low-profile ladder filter, an insulating material is required for the adhesive layer 9. The insulation of the adhesive layer 9 made from an insulating material may deteriorate due to migration, and in the worst case, it may lead to a fatal defect, that is, a short-circuit among the pattern electrodes 6a to 6d. Between the pattern electrodes 6a to 6d and the cap 8, a capacitance may be generated, causing an adverse effect on the characteristics.

### SUMMARY OF THE INVENTION

Accordingly, a main object of the present invention is to provide an electronic component which has a surface-mountable, lamination-structure piezoelectric rest nator, which can be made to have a low profile, and in which a defect caused by a short-circuit is unlikely to occur, and an adverse effect on the characteristics is unlikely to happen.

Another object of the present invention is to provide a ladder filter which has a surface-mountable, lamination-structure piezoelectric resonator, which can be made to have a low profile, and in which a defect caused by a short-circuit is unlikely to occur, and an adverse effect on the characteristics is unlikely to happen.

The present invention provides an electronic component comprising:a substrate including via holes; a pattern electrode provided on a first major surface of said substrate; a ground electrode provided around said pattern electrode on the first major surface of said substrate; an external input and output electrode provided on a second major surface of said substrate and connected to said pattern electrode through one of said via holes of said substrate; an external ground electrode provided on the second major surface of said substrate and connected to said ground electrode through the other of said via holes of said substrate; a piezoelectric resonator vibratable in a longitudinal mode and connected to said pattern electrode provided on the first major surface of said substrate; a metal cap covering said piezoelectric resonator and bonded to said ground electrode provided on the first major surface of said substrate with electrically conductive adhesive; and said piezoelectric resonator including: a base member having a longitudinal direction; a plurality of internal electrodes disposed perpendicularly to the longitudinal direction of said base member at an interval in the longitudinal direction of said base member; and two external electrodes provided on a side surface of said base member and connected to said plurality of internal electrodes, said base member including a plurality of laminated piezoelectric layers, said plurality of piezoelectric layers being polarized in the longitudinal direction of said base member, and said plurality of internal electrodes being provided on surfaces perpendicular to the longitudinal direction of said base member in said piezoelectric layers.

The above electronic component may comprise a plurality of said piezoelectric resonators. In this case, a ladder filter comprising above electronic component can be obtained.

In an electronic component and a ladder filter according to the present invention, since the piezoelectric resonator has a lamination structure and is of a stiffened type, in which the polarization direction, the direction of the electric field, and the vibration direction are the same. Therefore, as compared with an unstiffened piezoelectric resonator, in which the vibration direction differs from the polarization direction and the electric-field direction, the stiffened piezoelectric resonator can have a larger electromechanical coupling coefficient and a larger selection range of the difference ΔF between the resonant frequency and the antiresonant frequency. In addition, with the use of the stiffened piezoelectric resonator, vibrations in a mode, such as a width mode or a thickness mode, which is different from the longitudinal vibration mode, is unlikely to occur and a spurious resonance becomes small.

In an electronic component and a ladder filter according to the present invention, since the two external electrodes are provided on one side surface of the base member of the piezoelectric resonator, the piezoelectric resonator can be surface-mounted on the substrate.

In an electronic component and a ladder filter according to the present invention, since the pattern electrodes on the first major surface of the substrate are not extended to edges of the substrate, and are connected to the external input and output electrodes on the second major surface of the substrate through via holes of the substrate, the pattern electrodes become short and thereby large inductive components are not generated. Therefore, the characteristics are improved in a high-frequency band, such as the MHz band.

Since the metal cap is used in an electronic component and a ladder filter according to the present invention, the cap can be easily made thinner or the drawing height can be easily reduced, allowing the filter to have a low profile.

In an electronic component and a ladder filter according to the present invention, since the metal cap is bonded to the ground electrodes around the pattern electrodes on the first major surface of the substrate, a defect due to a short circuit among the pattern electrodes is unlikely to occur. In addition, a capacitance is not generated between the cap and the ground electrodes on the first major surface of the substrate, and an adverse effect is unlikely to be made on the characteristics.

Other features and advantages of the present invention will become apparent from the following description of the invention which refers to the accompanying drawings.

### BRIEF DESCRIPTION OF THE DRAWINGS

Fig. 1 is a perspective view of a ladder filter according to the present invention.
Fig. 2 is an exploded perspective view of the ladder filter shown in Fig. 1.
Fig. 3 is a plan of the ladder filter shown in Fig. 1.
Fig. 4 is a cross section of the ladder filter shown in Fig. 1.
Fig. 5 is a circuit diagram of the ladder filter shown in Fig. 1
Fig. 6 is a perspective view of a piezoelectric resonator used for the ladder filter shown in Fig. 1.
Fig. 7 is a view of the piezoelectric resonator shown in Fig. 6.
Fig. 8 is a plan of a main section of the piezoelectric resonator shown in Fig. 6.
Fig. 9 is a perspective view of an electronic component, a discriminator, according to the present invention.
Fig. 10 is an exploded perspective view of the discriminator shown in Fig. 9.
Fig. 11 is a plan of the discriminator shown in Fig. 9.
Fig. 12 is a cross section of the discriminator shown in Fig. 9.
Fig. 13 is a view of a piezoelectric resonator used for the discriminator shown in Fig. 9.
Fig. 14 is a plan showing electrodes used for the piezoelectric resonator shown in Fig. 13.
Fig. 15 is a perspective view of a conventional piezoelectric resonator serving as a background of the present invention.
Fig. 16 is a perspective view of a ladder filter serving as a background of the present invention.
Fig. 17 is an exploded perspective view of the ladder filter shown in Fig. 16.
Fig. 18 is a plan of the ladder filter shown in Fig. 16.
Fig. 19 is a cross section of a main portion of the ladder filter shown in Fig. 16.
Fig. 20 is a circuit diagram of the ladder filter shown in Fig. 16.

### PREFERRED EMBODIMENTS OF THE PRESENT INVENTION

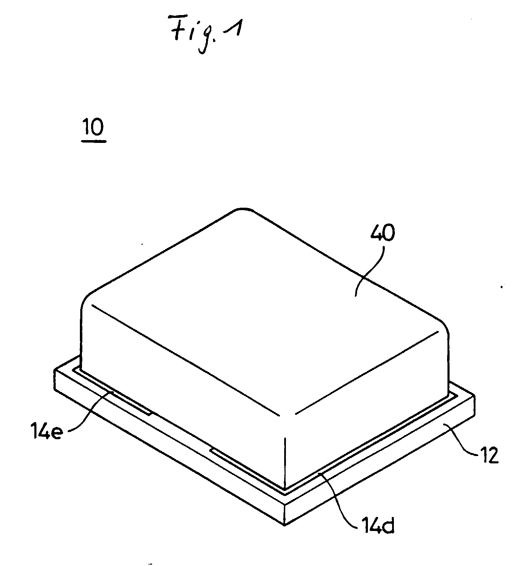

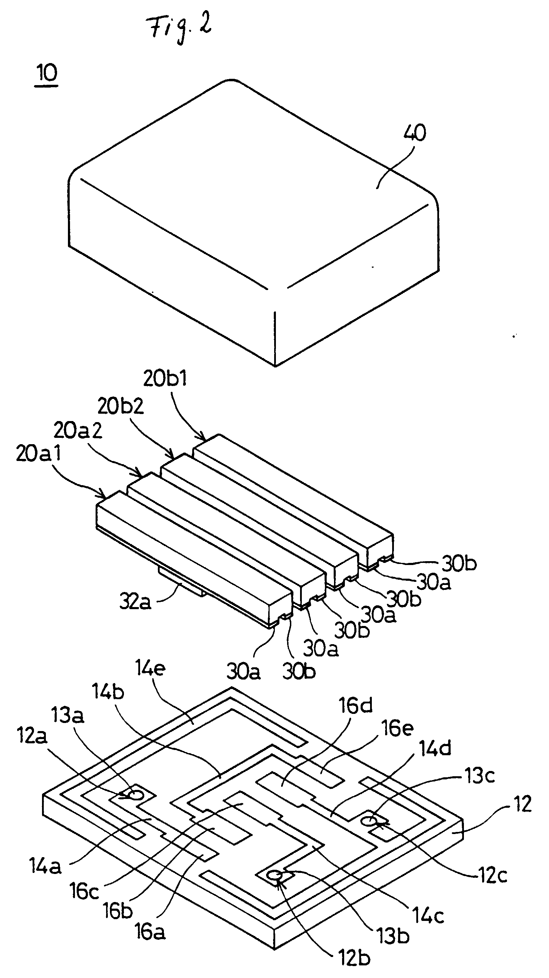

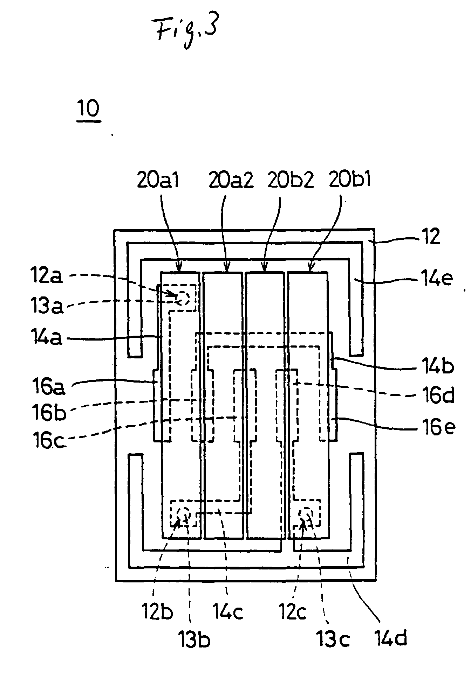

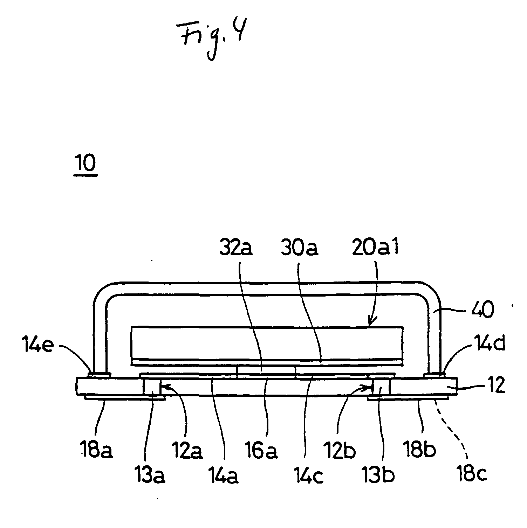

Referring to Figs. 1 to 8, the ladder filter 10 shown in Fig. 1 includes, for example, a rectangular-plate-shaped substrate 12. The substrate 12 is, for example, formed of a ceramic substrate made from ceramic such as alumina. In the substrate 12, three via holes 12a, 12b, and 12c are formed away from each other.

Within the via holes 12a, 12b, and 12c of the substrate 12, conductors 13a, 13b, and 13c made from, for example, Cu are formed.

On a first major surface of the substrate 12, five pattern electrodes 14a, 14b, 14c, 14d, and 14e made from, for example, Cu are provided. The pattern electrode 14a is connected to the conductor 13a in the via hole 12a. The pattern electrode 14c is connected to the conductor 13b in the via hole 12b. The pattern electrodes 14d serves as a ground electrode and is connected to the conductor 13c in the via hole 12c. The pattern electrode 14d is provided along one end of the substrate 12 in a C-shaped manner with two right angles. The pattern electrode 14e serves as a ground electrode and is provided along the other end of the substrate 12 in a C-shaped manner with two right angles.

Five lands 16a, 16b, 16c, 16d, and 16e made from, for example, Cu are formed in line with gaps on the pattern electrodes 14a to 14d. In this case, the lands 16a to 16d are provided at ends of the pattern electrodes 14a to 14d, and the land 16e is formed at the other end of the pattern electrode 14b.

On the second major surface of the substrate 12, three pattern electrodes 18a, 18b, and 18c made from, for example, Cu are provided. The pattern electrode 18a serves as an external input and output electrode and is connected to the conductor 13a in the via hole 12a. The pattern electrode 18b serves as an external input and output electrode and is connected to the conductor 13b in the via hole 12b. The pattern electrode 18c serves as an external ground electrode and is connected to the conductor 13c in the via hole 12c. The ends of the pattern electrodes 18a to 18c are provided away from the edges of the substrate by a gap of about 0.05 mm to 0.3 mm in order to prevent solder from attaching to the end faces of the substrate 12 when the ends of the pattern electrodes 18a to 18c are soldered, in other words, in order not to provide a fillet.

On the lands 16a to 16e of the pattern electrodes 14a to 14d on the first major surface of the substrate 12, four piezoelectric resonators 20a1, 20a2, 20b2, and 20b1 are disposed in line in this order. Two piezoelectric resonators 20a1 and 20a2 serve as series resonators having the same structure, and the other two piezoelectric resonators 20b1 and 20b2 serve as parallel resonators having the same structure. The piezoelectric resonators 20b1 and 20b2, serving as parallel resonators, are designed to have much larger capacitances than the piezoelectric resonators 20a1 and 20a2, serving as series resonators. Since the piezoelectric resonators 20a1 and 20a2 and the piezoelectric resonators 20b1 and 20b2 are different in length due to different capacitances, but have the similar structures, one piezoelectric resonator 20a1 will be described below in detail.

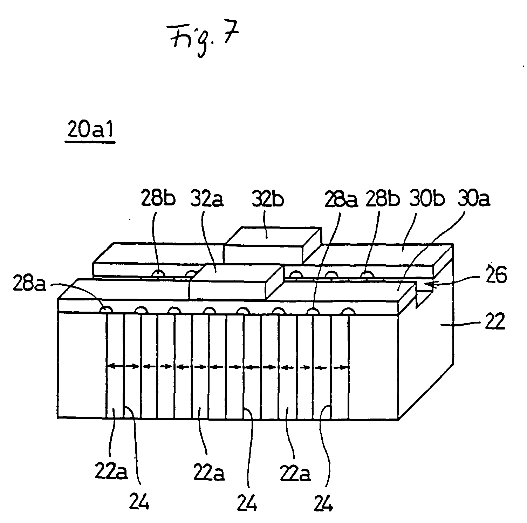

The piezoelectric resonator 20a1 includes, for example, a rectangular-parallelepiped base member 22. The base member 22 includes, for example, a plurality of laminated piezoelectric layers 22a made from piezoelectric ceramic. On both main surfaces of a plurality of piezoelectric layers 22a, which are perpendicular to the longitudinal direction of the base member 22, a plurality of internal electrodes 24 are provided at an intermediate portion of the base member 22 in the longitudinal direction. This means that the plurality of internal electrodes 24 are disposed perpendicularly to the longitudinal direction of the base member 22 at a certain interval in the longitudinal direction of the base member 22. The plurality of piezoelectric layers 22a disposed at the intermediate portion of the base member 22 in the longitudinal direction are polarized in the longitudinal direction of the base member 22 as shown by arrows in Fig. 7 such that adjacent piezoelectric layers 22a are polarized in opposite directions. Piezoelectric layers 22a disposed at both ends of the base member 22 in the longitudinal direction are not polarized.

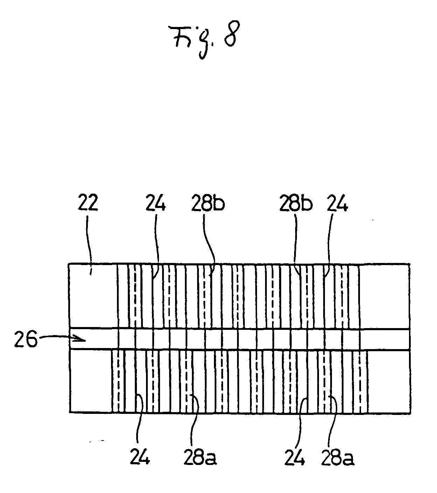

On one side surface of the base member 22, a groove 26 extending in the longitudinal direction of the base member 22 is provided. The groove 26 is provided at the center in the width direction of the base member 22 and divides the side face into two parts. As shown in Fig. 8, on the side surface divided by the groove 26, first insulating films 28a and second insulating films 28b are provided. At one side of the side surface of the base member 22 divided by the groove 26, the first insulating films 28a cover the exposed portions of alternate internal electrodes 24. At the other side of the side surface of the base member 22 divided by the groove 26, the second insulating films 28b cover the exposed portions of the other alternate internal electrodes 24, which are not covered by the first insulating films 28a at the one side of the groove.

In the portions where the first and second insulating films 28a and 28b are provided on the base member 22, namely, on both sides of the groove 26, two external electrodes 30a and 30b are provided. Therefore, the external electrode 30a connects to internal electrodes 24 which are not covered by the first insulating films 28a, and the external electrode 30b connects to internal electrodes 24 which are not covered by the second insulating films 28b. In other words, adjacent internal electrodes 24 are connected to the external electrodes 30a and 30b, respectively.

At the centers of the external electrodes 30a and 30b in the longitudinal direction, support members 32a and 32b are provided, respectively. These support members 32a and 32b are made from an electrically conductive material.

The piezoelectric resonator 20a1 uses the external electrodes 30a and 30b as input and output electrodes. Since the piezoelectric layers disposed at the intermediate section in the longitudinal direction of the base member 22 are polarized between adjacent internal electrodes 24 and an electric field is applied between the adjacent electrodes 24, the piezoelectric layers are piezoelectrically active. In this case, because voltages are applied in opposite directions to the piezoelectric layers 22a constituting the base member 22 which are polarized in opposite directions, the base member 22 expands and contracts in the same direction as a whole. Therefore, the entire piezoelectric resonator 20a1 vibrates in the longitudinal direction in a basic mode with the center of the base member 22 in the longitudinal direction serving as a node. At both ends of the base member 22 in the longitudinal direction, piezoelectric layers are not polarized and an electric field is not applied due to lack of internal electrodes, the layers are piezoelectrically inactive.

In the piezoelectric resonator 20a1, the polarization direction of the base member 22, the applied electric field direction due to an input signal, and the direction of vibration in the base member 22 are all the same. In other words, the piezoelectric resonator 20a1 is of a stiffened type. The piezoelectric resonator 20a1 has a larger electromagnetic coupling coefficient than an unstiffened piezoelectric resonator, in which the direction of vibration differs from the direction of polarization and electric field. Therefore, the piezoelectric resonator 20a1 has a larger selection range of the frequency difference ΔF between the resonant frequency and the antiresonant frequency than an unstiffened piezoelectric resonator. This means that the piezoelectric resonator 20a1 obtains wide-frequency-band characteristics as compared with an unstiffened piezoelectric resonator.

In this piezoelectric resonator 20a1, the capacitance of the resonator can be adjusted by changing the opposing area of internal electrodes 24, the number of the piezoelectric layers 22a, or the electrodes 24, or the dimensions of the piezoelectric layers 22a in the longitudinal direction of the base member 22. In other words, the capacitance can be increased by extending the opposing area of internal electrodes 24, by increasing the number of the piezoelectric layers 22a, or the electrodes 24, or by reducing the dimensions of the piezoelectric layers 22a in the longitudinal direction of the base member 22. In contrast, the capacitance can be reduced by reducing the opposing area of internal electrodes 24, by reducing the number of the piezoelectric layers 22a, or the electrodes 24, or by increasing the dimensions of the piezoelectric layers 22a in the longitudinal direction of the base member 22. Therefore, by adjusting the opposing area of internal electrodes 24 in the piezoelectric resonator 20a1, the number of the piezoelectric layers 22a, or the electrodes 24, or the dimensions of the piezoelectric layers 22a in the longitudinal direction of the base member 22, the capacitance is adjusted. This means that a high degree of freedom is given to capacitance design. Therefore, it is easy to achieve impedance matching with an external circuit when the piezoelectric resonator 20a1 is mounted on a circuit board.

In this ladder filter 10, on the land 16a of the pattern electrode 14a, the support member 32a provided on the external electrode 30a in the piezoelectric resonator 20a1, which serves as the first series resonator, is bonded with electrically conductive adhesive, and thereby the external electrode 30a of the piezoelectric resonator 20a1 is connected to the pattern electrode 14a.

In the same way, on the land 16b of the pattern electrode 14b, the support member 32b of the piezoelectric resonator 20a1 and the support member 32a of the piezoelectric resonator 20a2, which serves as the second series resonator, are bonded with electrically conductive adhesive, and thereby the external electrode 30b of the piezoelectric resonator 20a1 and the external electrode 30a of the piezoelectric resonator 20a2 are connected to the pattern electrode 14b.

On the land 16c of the pattern electrode 14c, the support member 32b of the piezoelectric resonator 20a2 and the support member 32a of the piezoelectric resonator 20b2, which serves as the second parallel resonator, are bonded with electrically conductive adhesive, and thereby the external electrode 30b of the piezoelectric resonator 20a2 and the external electrode 30a of the piezoelectric resonator 20b2 are connected to the pattern electrode 14c.

On the land 16d of the pattern electrode 14d, the support member 32b of the piezoelectric resonator 20b2 and the support member 32a of the piezoelectric resonator 20b1, which serves as the first parallel resonator, are bonded with electrically conductive adhesive, and thereby the external electrode 30b of the piezoelectric resonator 20b2 and the external electrode 30a of the piezoelectric resonator 20b1 are connected to the pattern electrode 14d.

On the land 16e of the pattern electrode 14b, the support member 32b of the piezoelectric resonator 20b1 is bonded with electrically conductive adhesive, and thereby the external electrode 30b of the piezoelectric resonator 20b1 is connected to the pattern electrode 14b.

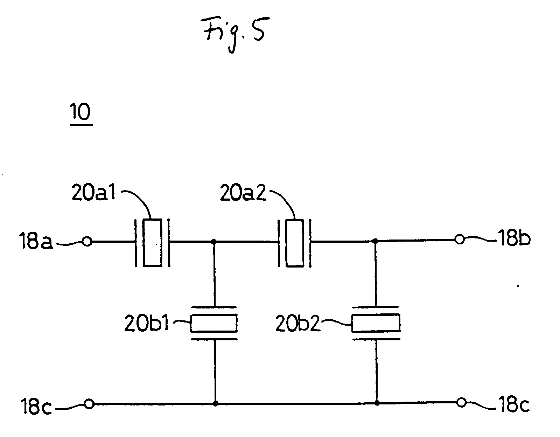

Therefore, the ladder filter 10 has a ladder circuit shown in Fig. 5. In other words, in this ladder filter 10, the pattern electrode 18a connected to the pattern electrode 14a serves as an external input and output electrode, the pattern electrode 18b connected to the pattern electrode 14c serves as an external input and output electrode, and the pattern electrode 18c connected to the pattern electrode 14d serves as a ground electrode.

In this ladder filter 10, a metal cap 40 is bonded to the substrate 12 so as to cover the piezoelectric resonators 20a1, 20a2, 20b1, and 20b2. In this case, the cap 40 is bonded to the pattern electrodes 14d and 14e with electrically conductive adhesive.

This ladder filter 10 is produced, for example, in the following way.

A ceramic green sheet used for the substrate 12 is molded.

The via holes 12a to 12c are formed in the ceramic green sheet.

In the via holes 12a to 12c and on the front surface and the rear surface of the ceramic green sheet, conductive paste having Cu as its main component, which will form the conductors 13a to 13c, the pattern electrodes 14a to 14e, the lands 16a to 16e, and the pattern electrodes 18a to 18c, is placed and printed.

Then, the ceramic green sheet and the conductive paste are sintered together at about 1000°C.

As required, on the pattern electrodes 14a to 14e, the lands 16a to 16e, and the pattern electrodes 18a to 18c, barrier metals, such as Ni and Au layers, Ni and Sn layers, or Ni and solder layers, are formed by plating.

Electrically conductive paste is applied to the lands 16a to 16e of the pattern electrodes 14a to 14d, the piezoelectric resonators 20a1, 20a2, 20b1, and 20b2 are mounted thereon, and the electrically conductive paste is hardened.

The electrically conductive paste is applied to the pattern electrodes 14d and 14e, disposed at the periphery, the metal cap 40 which was molded in drawing is placed thereon, and the electrically conductive paste is hardened.

If pattern electrodes may be short-circuited due to the electrically conductive paste, insulating adhesive may be partially used together with the electrically conductive paste.

In this ladder filter 10, each of the piezoelectric resonators 20a1, 20a2, 20b1, and 20b2 has a lamination structure.

In the ladder filter 10, since the two external electrodes 30a and 30b are provided on one side face of the base member 22 of each of the piezoelectric resonators 20a1, 20a2, 20b1, and 20b2, these piezoelectric resonators 20a1, 20a2, 20b1, and 20b2 can be surface-mounted on the substrate 12.

In this ladder filter 10, since the pattern electrodes 14a, 14b, and 14c on the first major surface of the substrate 12 are not extended to edges of the substrate 12, and the pattern electrodes 14a and 14c are connected to the pattern electrodes 18a and 18b on the second major surface of the substrate 12 through the via holes 12a and 12b, the pattern electrodes become short and thereby large inductive components are not generated. Therefore, the characteristics are improved in a high-frequency band, such as the MHz band.

Since the metal cap 40 is used in this ladder filter 10, the cap 40 can be easily made thinner or the drawing height can be easily reduced, allowing the filter to have a low profile.

Since the metal cap 40 is bonded to the pattern electrodes 14d and 14e, which serve as ground electrodes around the pattern electrodes 14a, 14b, and 14c on the first major surface of the substrate 12, in this ladder filter 10, a defect due to a short circuit among the pattern electrodes 14a, 14b, and 14c is unlikely to occur. In addition, a capacitance is not generated between the cap 40 and the pattern electrodes 14d and 14e, serving as ground electrodes on first major surface of the substrate 12, and an adverse effect is unlikely to be made on the characteristics.

Since the ends of the pattern electrodes 18a, 18b, and 18c are provided from the edges of the substrate 12 with gaps in this ladder filter 10, a fillet is not formed when the ends of the pattern electrodes 18a to 18c are soldered.

Because notches are not provided at the periphery of the substrate 12 in this ladder filter 10, when the cap 40 is bonded at the periphery of the substrate 12, an airtight condition is maintained within the cap 40. Therefore, as compared with the ladder filter 4 shown in Figs. 16 to 20, in which notches are provided at the periphery of the substrate, the ladder filter 10 allows the substrate 12 to be made compact while maintaining the airtight condition in the cap.

In this ladder filter 10, because the conductors 13a to 13c, the pattern electrodes 14a to 14e, the lands 16a to 16e, and the pattern electrodes 18a to 18c are made from Cu, which has a low resistivity, the characteristics are stable even in high frequencies, such as those ranging from the kHz band to the MHz band.

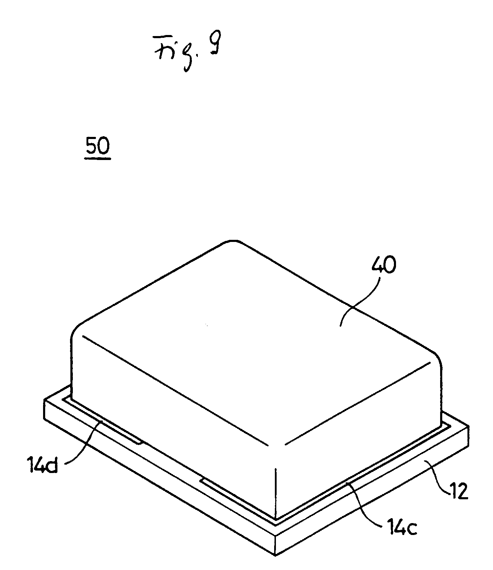

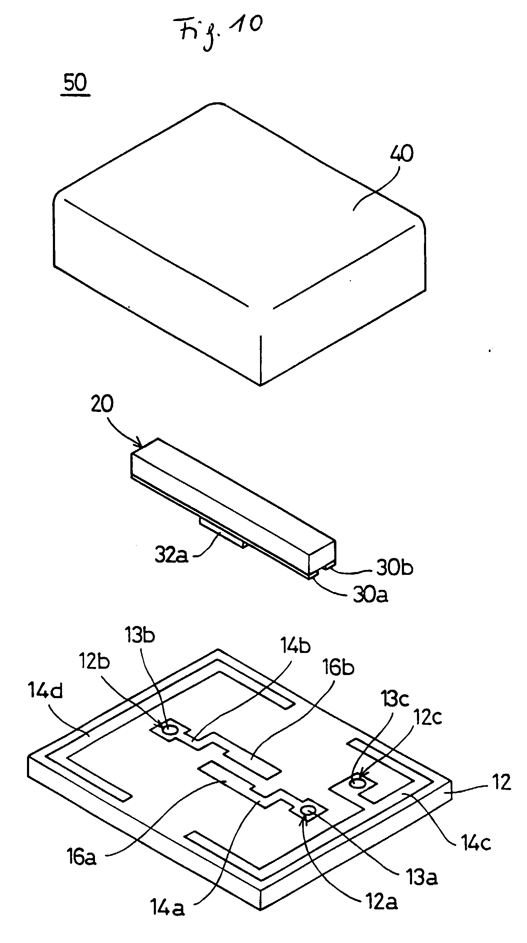

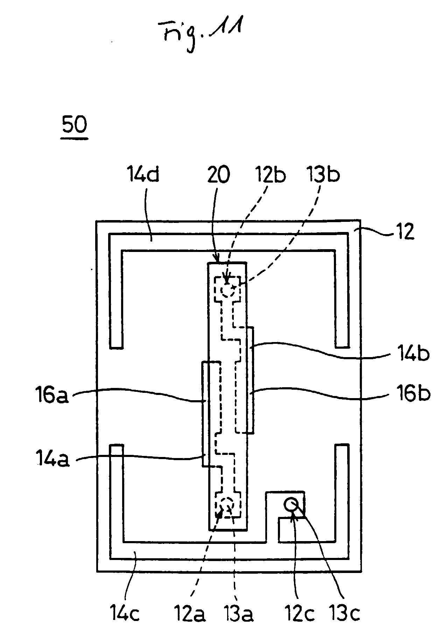

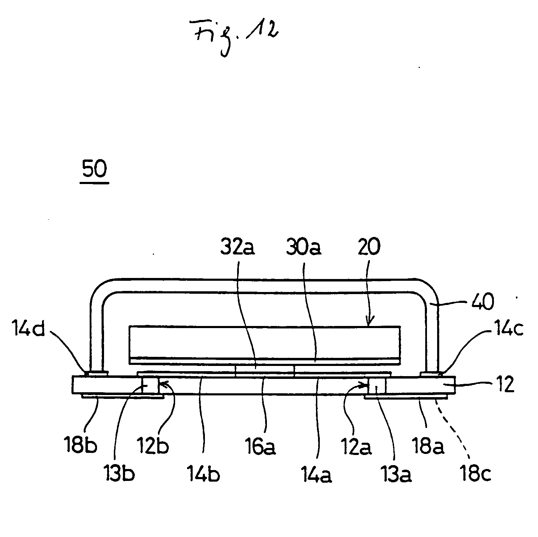

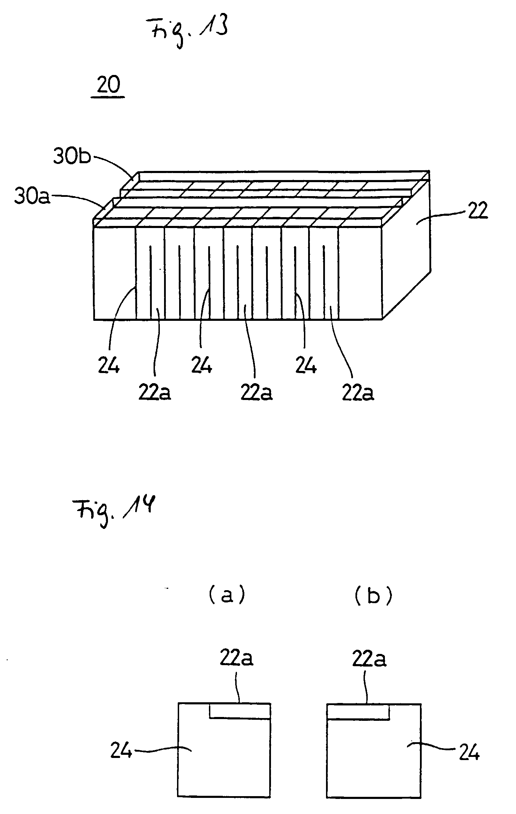

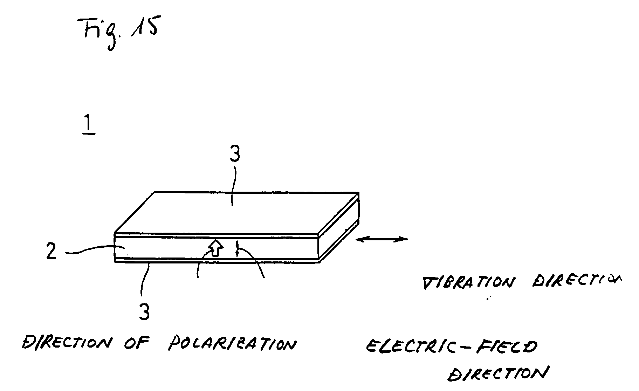

Fig. 9 is a perspective view of an electronic component, a discriminator, according to an embodiment of the present invention. Fig. 10 is an exploded perspective view of the discriminator, and Fig. 11 is a plan of the discriminator. Fig. 12 is a cross section of the discriminator. Fig. 13 is a view of a piezoelectric resonator used for the discriminator shown in Fig. 9. Fig. 14 is a plan of electrodes used for the piezoelectric resonator. The discriminator 50 shown in Fig. 9 includes, for example, a rectangular-plate-shaped substrate 12. The substrate 12 is, for example, formed of a ceramic substrate made from ceramic such as alumina. In the substrate 12, three via holes 12a, 12b, and 12c are formed with gaps.

Within the via holes 12a, 12b, and 12c of the substrate 12, conductors 13a, 13b, and 13c made from, for example, Cu are provided.

On the first major surface of the substrate 12, four pattern electrodes 14a, 14b, 14c, and 14d made from, for example, Cu are provided. The pattern electrode 14a is connected to the conductor 13a in the via hole 12a. The pattern electrode 14b is connected to the conductor 13b in the via hole 12b. The pattern electrodes 14c serves as a ground electrode and is connected to the conductor 13c in the via hole 12c. The pattern electrode 14c is provided along one end of the substrate 12 in a C-shaped manner with two right angles. The pattern electrode 14d serves as a ground electrode and is provided along the other end of the substrate 12 in a C-shaped manner with two right angles.

Two lands 16a and 16b made from, for example, Cu are formed on the pattern electrodes 14a and 14b. In this case, the lands 16a and 16b are formed at ends of the pattern electrodes 14a and 14b.

On the second major surface of the substrate 12, three pattern electrodes 18a, 18b, and 18c made from, for example, Cu are provided. The pattern electrode 18a serves as an external input and output electrode and is connected to the conductor 13a in the via hole 12a. The pattern electrode 18b serves as an external input and output electrode and is connected to the conductor 13b in the via hole 12b. The pattern electrode 18c serves as an external ground electrode and is connected to the conductor 13c in the via hole 12c. The ends of the pattern electrodes 18a to 18c are provided away from the edges of the substrate by a gap of about 0.05 mm to 0.3 mm in order to avoid a fillet.

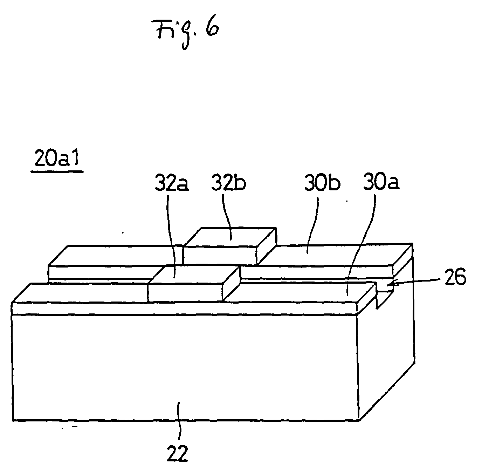

On the lands 16a and 16b of the pattern electrodes 14a and 14b on first major surface of the substrate 12, the piezoelectric resonator 20 shown in Fig. 13 is disposed. Unlike the above-described piezoelectric resonator 20a1 shown in Figs. 6 to 8, alternate internal electrodes 24 are provided on major surfaces of the piezoelectric layers 22a except for one end at an upper section as shown in Fig. 14(a) in the piezoelectric resonator 20 shown in Fig. 13, and the other alternate internal electrodes 24 are provided on major surfaces of the piezoelectric layers 22a except for the other end of the upper section as shown in Fig. 14(b). Since the internal electrodes 24 are provided in this way, one end of an edge of each of the alternate internal electrodes 24 or the other end of the edge of each of the other alternate internal electrodes 24 is not exposed on one side face of the base member 22. Therefore, unlike the piezoelectric resonator 20a1 described above, the insulating films 28a and 28b are not provided in the piezoelectric resonator 20 shown in Fig. 13.

In this discriminator 50, on the land 16a of the pattern electrode 14a, the support member 32a made of an electrically conductive material at the center of the external electrode 30a in the piezoelectric resonator 20 is bonded with electrically conductive adhesive, and thereby the external electrode 30a of the piezoelectric resonator 20 is connected to the pattern electrode 14a.

In the same way, on the land 16b of the pattern electrode 14b, the support member 32b made of an electrically conductive material at the center of the external electrode 30b in the piezoelectric resonator 20 is bonded with electrically conductive adhesive, and thereby the external electrode 30b of the piezoelectric resonator 20 is connected to the pattern electrode 14b.

Therefore, in this discriminator 50, the pattern electrode 18a connected to the pattern electrode 14a serves as an external input and output electrode, the pattern electrode 18b connected to the pattern electrode 14b serves as an external input and output electrode, and the pattern electrode 18c connected to the pattern electrode 14c serves as a ground electrode.

In this discriminator 50, the metal cap 40 is bonded to the substrate 12 so as to cover the piezoelectric resonator 20. In this case, the cap 40 is bonded to the pattern electrodes 14c and 14d with electrically conductive adhesive.

The discriminator 50 is produced in the same way as for the ladder filter 10 described above.

In this discriminator 50, the piezoelectric resonator 20 has a lamination structure.

In the discriminator 50, since the two external electrodes 30a and 30b are provided on one side face of the base member 22 of the piezoelectric resonator 20, the piezoelectric resonator 20 can be surface-mounted on the substrate 12.

In this discriminator 50, since the pattern electrodes 14a and 14b on first major surface of the substrate 12 are not extended to edges of the substrate 12, and are connected to the pattern electrodes 18a and 18b on the second major surface of the substrate 12 through the via holes 12a and 12b, the pattern electrodes become short and thereby large inductive components are not generated. Therefore, the characteristics are improved in a high-frequency band, such as the MHz band.

Since the metal cap 40 is used in this discriminator 50, the cap 40 can be easily made thinner or the drawing height can be easily reduced, allowing the filter to have a low profile.

Since the metal cap 40 is bonded to the pattern electrodes 14c and 14d, which serve as ground electrodes around the pattern electrodes 14a and 14b on the first major surface of the substrate 12, in this discriminator 50, a defect due to a short circuit between the pattern electrodes 14a and 14b is unlikely to occur. In addition, a capacitance is not generated between the cap 40 and the pattern electrodes 14c and 14d, serving as ground electrodes on first major surface of the substrate 12, and an adverse effect is unlikely to be made on the characteristics.

Since the ends of the pattern electrodes 18a, 18b, and 18c are provided with gaps from the edges of the substrate 12 in this discriminator 50, a fillet is not formed when the ends of the pattern electrodes 18a to 18c are soldered.

Because notches are not provided at the periphery of the substrate 12 in this discriminator 50, when the cap 40 is bonded at the periphery of the substrate 12, an airtight condition is maintained within the cap 40.

In this discriminator 50, because the conductors 13a to 13c, the pattern electrodes 14a to 14d, the lands 16a and 16b, and the pattern electrodes 18a to 18c are made from Cu, which has a low resistivity, the characteristics are stable even in high frequencies, such as those ranging from the kHz band to the MHz band.

In each of the above piezoelectric resonators 20 and 20a1, both ends of the base member 22 in the longitudinal direction are piezoelectrically inactive. Such a portion which is piezoelectrically inactive may be provided at a part of the base member 22 other than both ends thereof in the longitudinal direction. Alternatively, the entire base member 22 in the longitudinal direction may be formed to be piezoelectrically active.

In an electronic component and a ladder filter according to the present invention, another lamination-structure piezoelectric resonator which can be surface-mounted may be used.

In a ladder filter according to the present invention, the number of used piezoelectric resonators may be changed in a desired way.

The present invention can also be applied to other electronic components having a piezoelectric resonator, such as an oscillator and other filters.

While the invention has been particularly shown and described with reference to preferred embodiments thereof, it will be understood by those skilled man in the art that the forgoing and other changes in form and details may be made therein without departing from the spirit of the invention.

## Claims

1. an electronic component, comprising:
a substrate including via holes;
a pattern electrode provided on a first major surface of said substrate; a ground electrode provided around said pattern electrode on the first major surface of said substrate;
an external input and output electrode provided on a second major surface of said substrate and connected to said pattern electrode through one of said via holes of said substrate;
an external ground electrode provided on the second major surface of said substrate and connected to said ground electrode through the other of said via holes of said substrate;
a piezoelectric resonator vibratable in a longitudinal mode and connected to said pattern electrode provided on the first major surface of said substrate;
a metal cap covering said piezoelectric resonator and bonded to said ground electrode provided on the first major surface of said substrate with electrically conductive adhesive; and
said piezoelectric resonator including:
a base member having a longitudinal direction; a plurality of internal electrodes disposed perpendicularly to the longitudinal direction of said base member at an interval in the longitudinal direction of said base member; and
two external electrodes provided on a side surface of said base member and connected to said plurality of internal electrodes, said base member including a plurality of laminated piezoelectric layers, said plurality of piezoelectric layers being polarized in the longitudinal direction of said base member, and said plurality of internal electrodes being provided on surfaces perpendicular to the longitudinal direction of said base member in said piezoelectric layers.

2. The electronic component according to Claim 1, comprising a plurality of said piezoelectric resonators.

3. A ladder filter comprising the electronic component of Claim 2.
